# EUROPEAN PATENT APPLICATION

(11) **EP 2 835 657 A1**
(43) Date of publication of application: **11.02.2015**
(21) Application number: 14177425.7
(22) Date of filing: 17.07.2014
(51) Int. Cl.: G01R 27/20, G01V 3/02, H01B 7/36

(54) **Cable system and test cable therefore**

(30) Priority: 06.08.2013 US 201313960372
(71) Applicant: Fluke Corporation, Everett, WA 98203 (US)
(72) Inventor: Silva, Luis, Lynwood, WA 98036 (US)
(74) Representative: Lunt, Mark George Francis

(57) **Abstract**

An earth ground testing cable (100) is configured to electrically couple an electrode to a measurement unit. The cable may comprise an outer surface having at least a first marking (102) and a second marking. The first marking and the second marking define a segment (103) of cable having a length that corresponds to a spacing distance between the electrode and at least one other electrode for performing an earth ground test. The spacing distance may be determined based on electrical interference properties of a measurement unit and the one or more electrodes. The ground earth testing cable may be part of a system and may be used to determine positioning for electrodes. The cable may also couple an electrode to the testing unit, so that an earth ground reading is determined.

## Description

### BACKGROUND

A lack of good grounding for electrical systems may have a negative impact on power quality. A lack of good grounding may also increase the risk of damage to property or cause equipment to malfunction. In addition to maintaining power quality and decreasing the risk of equipment damage during normal operation, a well-designed grounding system can reduce the risk of damage caused by intermittent faults or lighting strikes. When designing a grounding system, it is important to know the soil properties where the grounding system is to be built.

Soil can be tested for earth ground resistivity and other grounding properties. One issue facing operators attempting to perform earth ground testing is that multiple stakes must be arranged in a very particular fashion in order to conduct the test. It is not uncommon for an earth ground test to specify a distance between stakes of 10 or more meters. Some earth ground tests, such as the fall-of-potential test, require moving one stake to multiple positions relative to the other stakes and obtaining measurements for each position. In addition, the entire system may need to be moved to avoid electrical interference from other stakes or metal objects buried in the ground between stakes. If the stakes are not accurately positioned, inaccurate earth ground measurements may result.

General purpose measurement equipment, such as surveying equipment, has been used to determine the proper arrangement of stakes. However, transporting, using, and maintaining measurement equipment requires a considerable amount of time and effort. To save time, operators may estimate distances without using such measurement equipment. Estimating distances can result in inaccurate or inconsistent earth ground measurements and inadequate grounding systems.

Earth ground testing can be time intensive due to the tasks that are required to perform a test. For example, the operator must ensure that a testing unit is connected to each stake. Wires are typically used to establish electrical connections between the measurement unit and the stakes. An operator may be required to walk back and forth several times between stakes to ensure accurate spacing between stakes and to connect each testing unit to each stake. If the time for performing an earth ground test is limited, more than one operator might be needed to perform the testing.

### SUMMARY

This summary is provided to introduce a selection of concepts in a simplified form that are further described below in the Detailed Description. This summary is not intended to identify key features of the claimed subject matter, nor is it intended to be used as an aid in determining the scope of the claimed subject matter.

In one aspect, a ground testing cable is provided. The ground testing cable has a first end that is couplable to an earth ground testing unit and a second end that is couplable to an electrode. The cable is configured to electrically couple the electrode to the measurement unit. The cable has an outer surface having at least a first marking and a second marking. The first marking and the second marking define a segment of cable having a length. The length of the segment of cable corresponds to a predetermined distance between the electrode and at least one other electrode when performing an earth ground test.

In another aspect, an earth ground testing system is provided. The system includes a measurement unit, a cable having a first end and a second end. The first end is couplable to the measurement unit and the second end is couplable to one or more of a first, second, third, or fourth electrodes. The cable is configured to electrically couple the measurement unit to one of the first, second, third, or fourth electrodes. A first marking and a second marking are disposed on the cable. The first marking and the second marking define a segment of cable having a length. The length of the cable segment corresponds to a spacing between at least two of the first, second, third, or fourth electrodes in order to perform an earth ground measurement.

In another aspect, an apparatus for providing earth ground measurements is provided. The apparatus includes a measurement unit, a conductive cable having a first end that is couplable to a first electrode and a second end that is couplable to a testing unit such that an electrical connection may be formed between the testing unit and the first electrode. The apparatus also includes one or more second electrodes. The first electrode and the one or more second electrodes are configured to be disposed in the earth, wherein the one or more second electrodes are couplable to the measurement unit. The cable comprises distance measurement means.

In yet another aspect, a method of performing an earth ground test is provided. The method includes the steps of aligning a first marking on a cable with an earth position of a first electrode, moving a second electrode to an earth position that aligns with a second marking on the cable, moving a third electrode to an earth position that aligns with a third marking on the cable, and coupling one of the electrodes to a measurement unit with the cable and coupling the other electrodes to the measurement unit. The method also includes taking a first earth ground reading.

### DESCRIPTION OF THE DRAWINGS

The foregoing aspects and many of the attendant advantages of this invention will become more readily appreciated as the same become better understood by reference to the following detailed description, when taken in conjunction with the accompanying drawings, wherein:
FIGURE 1 is a front view of one example of a cable with markings for spacing electrodes and conducting an earth ground test in accordance with one or more embodiments of the present disclosure;
FIGURE 2 is a front view of one example of a reel and a cable with markings for spacing electrodes and conducting an earth ground test in accordance with one or more embodiments of the present disclosure;
FIGURE 3 is a front view of one example of a cable with markings for setting up spacing between electrodes and conducting an earth ground test in accordance with one or more embodiments of the present disclosure;
FIGURE 4 is a front view of a section of a cable that includes markings for setting up spacing between electrodes and conducting a fall-of-potential test or a soil resistivity test in accordance with one or more embodiments of the present disclosure;
FIGURE 5 is a schematic diagram of an example of a system suitable for conducting a soil resistivity test in accordance with one or more embodiments of the present disclosure;
FIGURE 6 is a schematic diagram of one example of a system suitable for conducting a fall-of-potential test in accordance with one or more embodiments of the present disclosure; and
FIGURE 7 is a flow chart diagram depicting one example of a method for positioning electrodes and conducting an earth ground measurement in accordance with an embodiment of the present disclosure.

### DETAILED DESCRIPTION

Embodiments of the present disclosure are generally directed to earth ground testing systems, methods, and associated cabling that use markings on a conductive cable to position one or more electrodes at an earth position relative to an earth position of one or more other electrodes. The cabling is also used to connect an electrode to a measurement unit to obtain an earth ground reading. Examples of the cables, described herein, include markings that correspond to a spacing distance between electrodes for performing particular earth ground tests. Examples of the cables, systems, and related methods allow an operator to set up and perform earth ground measurements with greater reliability and accuracy than current systems and methods. In addition, the earth ground testing systems, methods, and related cabling allow for testing to be performed more efficiently and with less hassle than currently available systems and methods. Earth ground tests are disclosed in U.S. Patent Application No. 12/625,269 (US Patent No 8,390,299), which is hereby incorporated by reference in its entirety.

While some embodiments are illustrated and described, it will be appreciated that various changes can be made therein without departing from the spirit and scope of the disclosure. Each embodiment described in this disclosure is provided merely as an example or illustration and should not be construed as preferred or advantageous over other embodiments. The illustrative examples provided herein are not intended to be exhaustive or to limit the disclosure to the precise forms disclosed. Additionally, it will be appreciated that embodiments of the present disclosure may employ any combination of the features described herein.

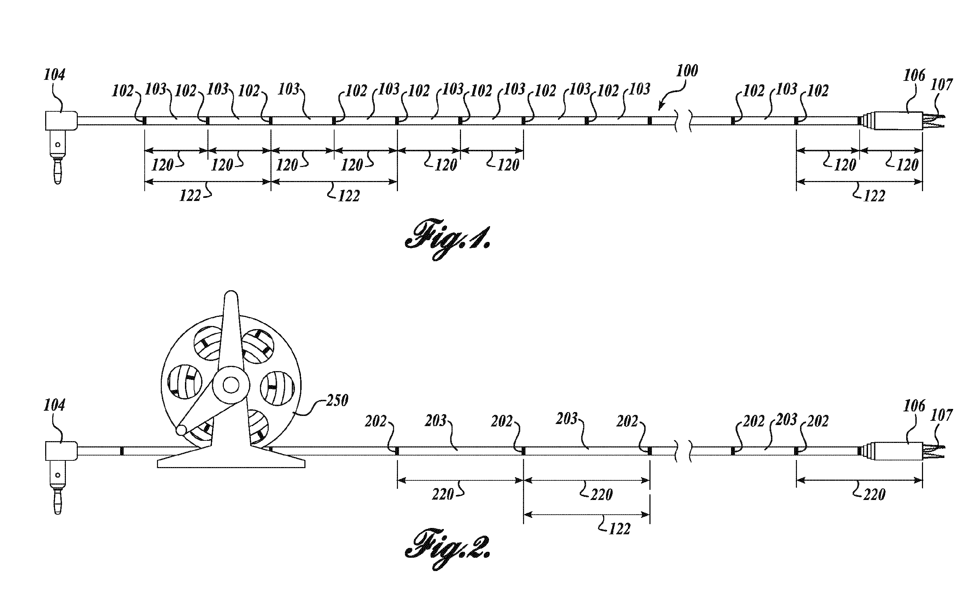

FIGURE 1 shows one example of a cable 100 used for configuring and performing an earth ground measurement. The cable 100 includes a measurement unit (MU) connector 104 at a first end and an electrode connector 106 at a second opposite end. One example of the MU that may be practiced with embodiments of the present disclosure is the Fluke 1625 GEO Earth Ground Tester manufactured by Fluke Corporation. The MU connector 104 may be any connector suitable for interfacing and forming an electrical connection with an MU. The MU connector 104 provides electrical coupling between the cable 100 and the MU. Cable 100 may include one or more bendable materials. Cable 100 is conductive, thereby permitting voltages and currents presented at the electrode to be transmitted by the cable 100 through electrode connector 106 for input into the MU via the MU connector 104. One example of a cable and MU connector that may be practiced with embodiments of the present disclosure is incorporated into Fluke GEO Reel 25 M manufactured by Fluke Corporation.

The electrode connector 106 is any suitable connector for electrically coupling the cable 100 to a wide range of types of electrodes such as stakes, earth elements, or grounding rods. In one embodiment, the electrode connector 106 includes an alligator-type sprung clip with serrated jaws, where a spring forces the jaws to maintain contact with a portion of an electrode thereby maintaining an electrical connection. One example of an alligator-type electrode connector that may be practiced with embodiments of the present disclosure is incorporated into Fluke GEO Reel 25 M. In some embodiments the cable 100 is permanently coupled to an electrode. In such embodiments, the electrode connector 106 may be screwed or welded to the electrode thereby placing the electrode connector 106 in direct contact with the electrode.

In some embodiments, electrode connector 106 is a clamp that provides an electrical coupling between the cable 100 without requiring that the electrode connector 106 be physically touching the electrode. Using a clamp as an electrical connector may lower the risk of operator error and also reduce the time devoted to troubleshooting the system due to loose or faulty connections between the electrode connector 106 and an electrode. One example of a clamp that may be practiced with embodiments of the present disclosure for providing a wireless electrical coupling to an electrode is included in the Fluke 1625 GEO Ground Tester kit.

Still referring to FIGURE 1, the cable 100 has an outer surface that includes a plurality of markings 102. As used herein, a marking refers to a portion of the cable 100 having a different color, visual appearance, light-reflective properties, or other indication compared to an adjacent portion of the cable 100. In some embodiments, the markings 102 have a band shape that extends in a perpendicular direction to a transverse horizontal axis of the cable 100. In the embodiment shown, the markings 102 of the cable 100 are each separated from an adjacent marking 102 by about the same distance when the cable 100 is straightened. Adjacent markings 102 define one or more cable segments 103 each having a segment length 120.

In a representative embodiment, the segment length 120 of the cable segments 103 is predetermined based on a spacing distance 122 between a plurality of electrodes for conducting an earth ground test. The segment length 120 is about half the spacing distance 122. In some embodiments, the segment length 120 is the desired electrode spacing distance 122 divided by an integer. In other words, if the spacing distance 122 between electrodes is 10 meters, the markings 102 may be positioned on the cable 100 such that the segment length 120 is 10 m/4 = 2.5 m, 10 m/3 = 3.33 m, 10 m/2 = 5 m, or 10 m/l = 10 m, as examples. Determining a segment length 120 by dividing a spacing distance 122 between electrodes by an integer allows an operator of the earth ground testing device to quickly determine the spacing distance 122 between electrodes by counting up markings 102 or cable segments 103 defined by the markings 102. Once the number of cable segments 103 or the markings corresponding to the spacing distance 122 between electrodes has been determined, an electrode may be aligned with one marking and another electrode may be moved to an earth position that aligns with another marking, where the length of the cable segment between the one marking and the other marking is about the length of the spacing distance 122. As used herein, "about" means within a variance of 5%. It is understood that the measurement lengths and positioning of electrodes do not need to be exact to obtain valid ground earth testing results.

In some embodiments, a contact point 107 where the electrode connector 106 touches an electrode and a marking 102 located adjacent to the electrode connector 106 may define a length that is about the segment length 120. Such spacing between contact point 107 and an adjacent marking allows the cable 100 to be used to determine earth positions for other electrodes while the cable 100 is connected to an electrode. When measuring the spacing distance 122 using markings 102, a portion of the cable 100 between the markings 102 that is used to determine the spacing distance should be straightened. If the cable 100 is coiled or curved, the distance between markings 102 is unrelated to the spacing distance 122. It may be desirable to couple the cable 100 to the electrode to provide an anchoring point for straightening the cable 100 or as a common reference point for making other measurements.

The markings 102 may have various shapes and forms. As examples, the markings 102 may overlay the outer surface of the cable 100, or the markings 102 could be embedded into an insulator material that forms an outer portion of the cable 100. In some embodiments, the markings 102 are printed on the outer surface of the cable 100. As an example, the markings 102 may have a black or a shiny metallic color and the adjacent cable segments 103 of cable 100 may be a red color. Other colors and reflective properties are possible. The markings 102 may include letters or symbols. In a representative embodiment, different color cable segments 103 having segment length 120 are arranged in an alternating fashion. In such an embodiment, the markings 102 are points on the cable 100 that correspond to color changes on the cable 100. The markings 102 may extend lengthwise on the cable 100. The length of the transverse horizontal segment of the cable 100 containing the marking 102 can generally be smaller than adjacent cable segments 103 of the cable 100 so that the marking may be quickly spotted by an operator. The marking 102 may also have a shape that may be easily aligned with an electrode.

In some embodiments, the markings 102 are different colors. For example, the markings 102 could be green, blue, and black, while the cable 100 can be yellow. In some embodiments, the color of the markings 102 alternates, e.g., black, blue, black, blue, etc. Markings 102 of different color may correspond to different spacing distances 122 between electrodes or different earth ground tests.

In some embodiments, the cable 100 includes only two markings 102 that define the cable segment 103 with a segment length 120 that is about the same as the spacing distance 122. Cables with two or three markings 102 corresponding to the spacing distance 122 may be easier to manufacture and modify to be compatible with different earth ground tests that call for different spacing distances between electrodes.

FIGURE 2 depicts an embodiment of cable 200 used for configuring and performing an earth ground test. The cable 200 includes a plurality of markings 202 that define a plurality of cable segments 203, where each cable segment 203 has a segment length 220. In cable 200, the segment length 220 is about the same as the spacing distance 122.

In the embodiment shown, the cable 200 is composed of materials that are sufficiently bendable so that the cable 200 may be coiled or wound on a reel 250. The reel 250 helps to prevent tangling of the cable 200, makes transporting to and from a testing site easier, and allows for the use of longer cables. The reel 250 also allows for the overall length of the cable 200 to be quickly increased or decreased. One example of a cable and reel suitable for earth ground testing is Fluke GEO Reel 25 M. A longer length cable and reel provide versatility and may be useful for spacing multiple electrodes. When used to space electrodes, the cable 200 should be straightened.

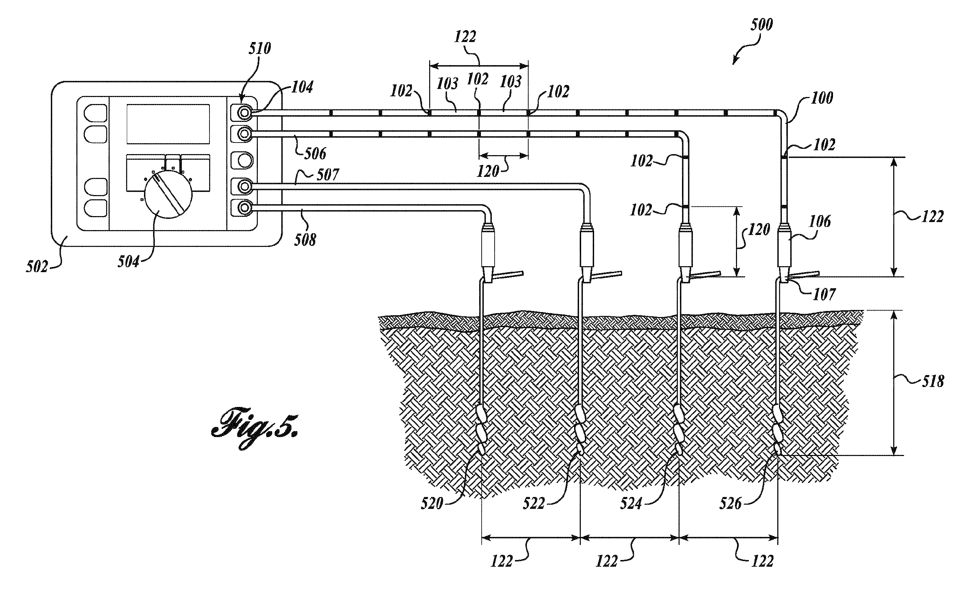

Referring now to FIGURE 5, an earth ground test system 500 is shown. The system 500 includes the cable 100 and one or more secondary cables 506, 507, and 508. Secondary cable 506 includes a plurality of markings 102 that define a plurality of cable segments 103 having segment lengths 120. Secondary cables 507 and 508 do not include markings. In some embodiments, all of the cables include markings 102.

The configuration of system 500 is suitable for performing a soil resistivity-type earth ground test. A MU 502 may provide readings and includes a rotatable switch 504 that controls a test type or other test or measurement setting. To configure the system 500 so that an earth ground measurement may be obtained, a stake 520, a stake 522, a stake 524, and a stake 526 are placed in the earth a depth 518. The stakes 520, 522, 524, and 526 function as earth ground electrodes. Stakes 520, 522, 524, and 526 are arranged in a line and each stake is separated from adjacent stakes by the spacing distance 122. In the system 500, the spacing distance 122 is approximately equal to two cable segments 103 defined by markings 102; however, other spacing distances 122 and segment lengths 120 may be used.

The stake 526 is aligned with a marking 102 on cable 100. The stake 524 is aligned with another marking 102 and is positioned the spacing distance 122 from the stake 526. The stake 522 is aligned with yet another marking 102 and is positioned a spacing distance 122 from the stake 524. The stake 520 is aligned with still another marking 102 and is positioned a spacing distance 122 from the stake 522. The cable 100 and the secondary cable 506 are shown with markings aligned, but this is not needed. It should be understood that once stakes 520, 522, 524, and 526 are at the desired earth positions determined using the markings 102, the cable 100 may be moved and a portion of the cable 100 may be curved or coiled when taking earth ground readings. The cable 100 does not need to be straightened when taking measurements.

The MU 502 is coupled to the stake 526 through the cable 100, specifically, the MU connector 104 is coupled to the MU 502 at an MU/cable interface 510, and the electrode connector 106 is coupled to the stake 526. The MU 502 is coupled to the stake 524 through the secondary cable 506. The secondary cable 506 is coupled to the MU 502 at the MU/cable interface 510. The secondary cable 507 couples the MU 502 to the stake 522. The secondary cable 508 couples the MU 502 to the stake 520. The secondary cable 507 and the secondary cable 508 are coupled to the measurement unit at the MU/cable interface 510.

Cables with or without markings may be substituted into systems 500 and 600 (disclosed below); however, at least one cable with markings should be used. Also, the MU/cable interface 510 allows cables to be switched to different inputs, and cables 100, 506, 507, and 508 may be switched between stakes 520, 522, 524, and 526. In addition, cables having different colors and using various color markings and spacing between markings, such as disclosed in connection with cables 100, 200, 300, and 400, may be substituted into the system 500 and the stakes repositioned in the earth consistent with the spacing provided. Furthermore, markings and spacing between cable segments defined by markings such as those disclosed in connection with cables 100, 200, 300, and 400 may be incorporated into a single cable. In one embodiment, markings and related spacing provided in cable 200 and cable 400 are combined into one cable suitable for positioning electrodes for conducting a soil resistivity test as well as a fall-of-potential test. In some embodiments, the markings for a fall-of-potential test and soil resistivity test may be provided on separate sections of a cable or the markings for each test may overlay each other.

The spacing distance 122 may be based on properties of system 500 or it may be based on standard testing procedures. For some ground earth tests, it is desirable to space electrodes based on a sphere of electrical influence for one or more of the electrodes so that that the electrodes do inadvertently interfere with each other. The spacing distance 122 is set to ensure that a sphere of influence for an electrode does not overlap with another electrode to avoid introducing electrical interference or noise at the other electrode. Among other things, the sphere of influence of an electrode depends on the MU used, a depth that the electrode is placed in the earth, and a surface area of the electrode that is placed in the earth. In some embodiments, the spacing distance 122 is set to about three times a depth that the electrode is placed in the earth because setting the spacing distance to about three times the electrode depth is about the distance needed to avoid overlap between spheres of influence for each electrode.

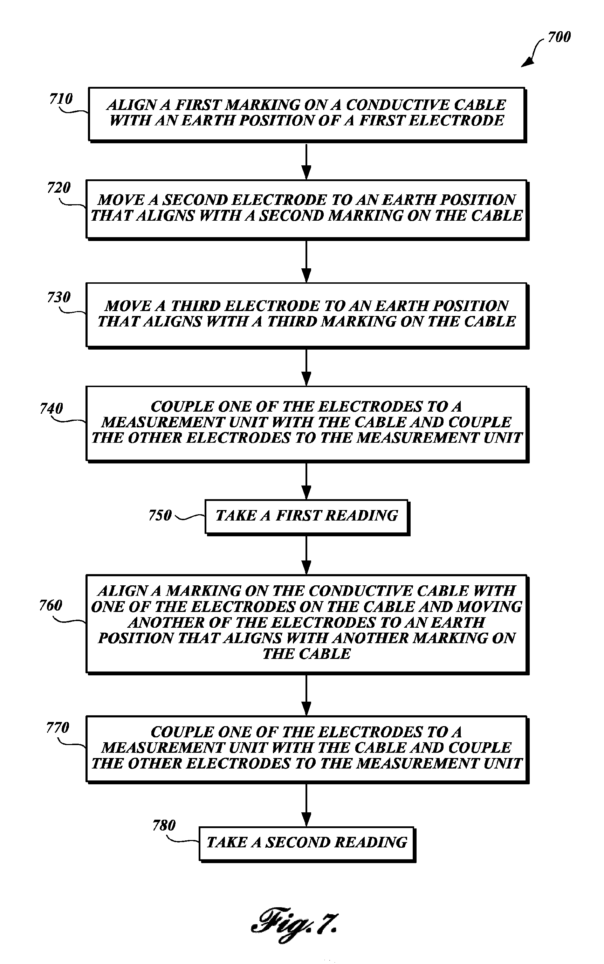

In some embodiments, the spacing distance 122 is determined to be slightly greater than the diameter of sphere of influence. More specifically, the spacing distance may be 100% to 120% of a diameter of a sphere of influence. In some embodiments, the spacing distance 122 is specified based on a testing protocol for a particular type of grounding system. The spacing distance 122 may be 10 meters to be compatible with a wide range of testing procedures. For a spacing distance of 10 meters, a segment length of 5 meters allows for efficient positioning of electrodes according to various earth ground testing procedures, such as the methods disclosed in FIGURE 7.

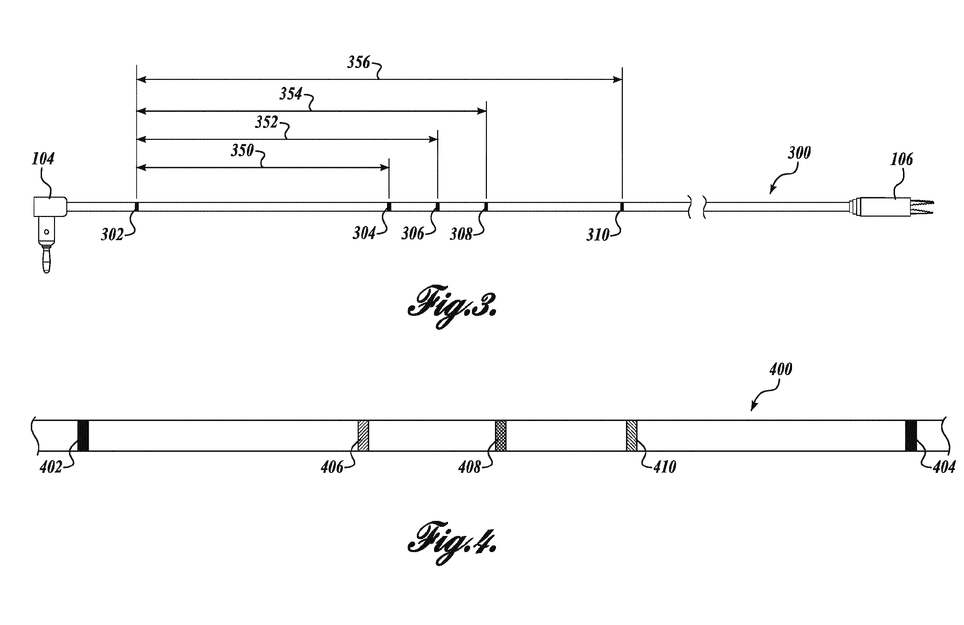

Referring now to FIGURE 3, an embodiment of a cable 300 suitable for configuring a fall-of-potential earth ground test is shown. The fall-of-potential test may use three electrodes arranged linearly with one electrode being positioned between the other two electrodes. It is also possible to perform a fall-of-potential test with four electrodes. For the fall-of-potential test using three electrodes, one electrode is moved to three different earth positions between the other two electrodes. Readings are obtained at each of the three locations. For example, a first electrode is aligned with a marking 302 and a second electrode is aligned with marking 310. A third electrode is aligned with each of markings 304, 306, and 308 and a measurement is performed at each position. Markings 304, 306, and 308 are spaced by spacing distance 350, 352, and 354, respectively, from marking 302. In one embodiment, the following spacing between markings is used: marking 304 is positioned 52% of a spacing distance 356 from marking 302 to marking 310; marking 306 is positioned 62% of the spacing distance 356 from marking 302 to marking 310; and marking 308 is positioned 72% of the spacing distance 356 from marking 302 to marking 310. Depending on the spacing between markings 302, 304, 306, 308, and 310, the cable 300 may also be used to arrange electrodes for other types of earth ground tests such as soil resistivity or selective measurement.

FIGURE 4 shows a segment of a cable 400 that may be used to arrange electrodes for an earth ground test. Markings 402 and 404 have a first color, marking 406 has a second color, marking 408 has a third color, and marking 410 has a fourth color. The first, second, third, and fourth colors may contrast with the colors of adjacent cable segments and/or a typical test earth ground environment. Each color may be used to designate a specific test or spacing between electrodes. For example, the first, second, and third colors may be used to designate electrode positions for a fall-of-potential test and markings of the first color may be used for a soil resistivity test. Associating markings of particular colors with earth ground tests can save operator time and may also reduce confusion.

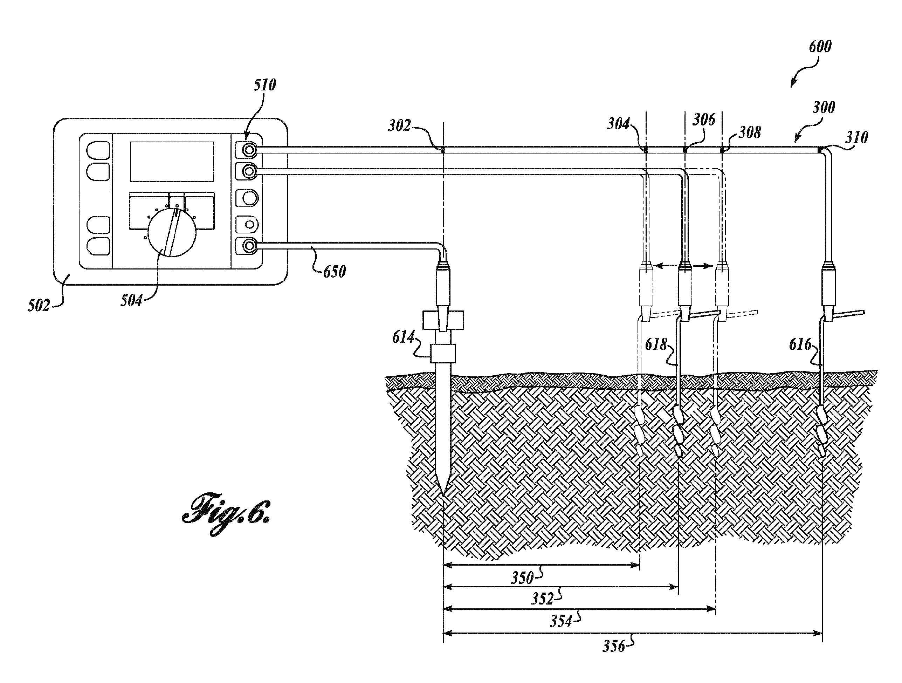

Referring to FIGURE 6, an earth ground testing system 600 is depicted with stakes arranged to perform a fall-of-potential test. A grounding element 614 is aligned with marking 302. The grounding element 614 may be part of a grounding system. The grounding element 614 may be a grounding rod, for example. A stake 616 is aligned with marking 310. A stake 618 is aligned with marking 306. The stake 618 could be moved to align with markings 304 and 308 to obtain additional readings. Aligning the grounding element 614 and stakes 616 and 618 with the markings 302, 304, 306, 308, and 310 allows an operator to space electrodes by the spacing distances 350, 352, 354, and 356.

The system 600 may be modified to perform a selective measurement ground test by adding a fourth cable that uses a clamp-type electrode connector 106 and coupling the fourth cable to the MU 502 with the MU connector 104. The MU 502 must be compatible with performing the selective measurement test. The fourth cable may include markings such as, but not limited to, the cables 100, 200, 300, or 400. In the selective measurement test, just as with the fall-of-potential test, two electrodes are positioned in the soil in a line extending away from a grounding element. The clamp is used to measure current flowing through an electrode of interest, which is used to determine the earth resistance. Two stakes 616 and 618 are spaced a spacing distance, which may be determined using one of the cables 100, 200, 300, or 400.

FIGURE 7 is a flow-chart of a method 700 of positioning electrodes and conducting an earth ground test. The method 700 may be used to perform various earth ground tests such as a selective test, a fall-of-potential test or a soil resistivity test. The method 700 could be used with cables 100, 200, 300, or 400 and use of grounding rods or stakes as electrodes. When using method 700, the cable disposed between the markings that are aligned with electrodes should be straightened when spacing electrodes. The cable does not need to be straightened when taking readings.

Beginning at block 710, a first marking on a conductive cable is aligned with an earth position of a first electrode. The first electrode may be a grounding rod or a stake. If the measurement involves a ground rod, it may be beneficial to treat the grounding rod as the first electrode because a grounding rod may have a fixed position or is not easily movable. At block 720, a second electrode is moved to an earth position that aligns with a second marking on the cable. The first electrode remains aligned with the first marking during block 720. At block 730, a third electrode is moved to an earth position that aligns with a third marking on the cable. The first electrode remains aligned with the first marking during block 730. The first electrode may be aligned with the first marking during block 720 or the second electrode may be aligned with the second marking at block 720.

At block 740, a MU is coupled to one of the first, second, or third electrodes using the cable. Also, at block 740 the other electrodes are coupled to the MU. Electrical coupling may be performed through wired connections or in relation to FIGURE 5 or with an inducing clamp. Block 740 may be performed before blocks 720 or 730, i.e., the cable may be coupled to one of the electrodes or the MU at blocks 720 or 720. At block 750, a first reading is measured by the MU.

At block 760, one of the electrodes is aligned with a marking on the cable and another electrode is moved to an earth position that aligns with another marking on the cable. Block 760 may be used with a selective test, a fall-of-potential test or to reposition an electrode for a soil resistivity test. The cable may be disconnected from the measurement unit or from any electrode prior to block 760. At block 780, a second reading is provided by the measurement unit. Any of the four electrodes may be re-positioned in a similar fashion. Before block 750, the method 700 further comprises the step of moving a fourth electrode to an earth position that aligns with a fourth marking on a cable.

While illustrative embodiments have been illustrated and described, it will be appreciated that various changes can be made therein without departing from the spirit and scope of the claimed subject matter.

## Claims

1. An earth ground testing cable comprising:
a first end that is couplable to a measurement unit and a second end that is couplable to an electrode, wherein the cable is configured to electrically couple the electrode to the measurement unit, and
an outer surface comprising at least a first marking and a second marking, wherein the first marking and the second marking define a segment of cable having a length,
wherein the length of the segment of cable corresponds to a predetermined distance between the electrode and at least one other electrode when performing an earth ground test.

2. An earth ground testing cable as claimed in Claim 1, wherein the outer surface of the cable further comprises a plurality of evenly spaced markings that define a plurality of cable segments, wherein the length of each segment is about equal to one of the predetermined distance or half of the predetermined distance.

3. An earth ground testing cable as claimed in Claim 1 or 2, wherein the length of the segment is based on a sphere of influence of the electrode.

4. An earth ground testing cable as claimed in Claim 1, 2 or 3, wherein the length is about 5 meters and the spacing corresponding to said predetermined distance between the electrode and the other electrode is about 10 meters.

5. An earth ground testing cable as claimed in any preceding claim, wherein the outer surface of the cable further comprises a third marking, and a fourth marking, wherein the first, second, third, and fourth markings correspond to the earth positions of electrodes when conducting a fall-of-potential test.

6. An earth ground testing cable as claimed in in any preceding claim, wherein the cable includes one or more bendable materials such that the cable may be coiled.

7. An earth ground testing system, comprising:
a measurement unit;
a first cable as claimed in any preceding claim;
further cables; and
a plurality of said electrodes couplable to said cables.

8. An earth ground testing system of Claim 7, wherein the first ends of the first, and further cables are electrically couplable to the measurement unit.

9. A method of performing an earth ground test comprising:
aligning a first marking on a conductive cable with an earth position of a first electrode;
moving a second electrode to an earth position that aligns with a second marking on the cable;
moving a third electrode to an earth position that aligns with a third marking on the cable;
coupling one of the electrodes to a measurement unit with the cable and coupling the other electrodes to the measurement unit; and
taking a first earth ground reading.

10. A method of performing an earth ground test as claimed in Claim 9, further comprising:
aligning a marking on the conductive cable with one of the first, second, or third electrodes and moving another of the first, second, or third electrodes to an earth position that aligns with another marking on the conductive cable; and
taking a second earth ground reading.

11. A method of performing an earth ground test as claimed in Claim 9 or 10, further comprising:
prior to taking the first reading, moving a fourth electrode to an earth position that aligns with a fourth marking on the cable.

12. A method of performing an earth ground test as claimed in Claim 9, 10 or 11, further comprising disposing a portion of each electrode in the earth at a depth, wherein a distance between two or more of the electrodes is about the same as the length of the cable between said markings.

13. A method of performing an earth ground test as claimed in any of Claims 9 to 12, wherein the portion of each electrode that is in the earth has a surface area, wherein the length of the cable between said markings is sized and configured based on said surface area.

14. A method of performing an earth ground test as claimed in any of Claims 9 to 13, wherein the portion of each electrode that is disposed in the earth corresponds to a plurality of said equidistantly spaced markings that define a plurality of evenly spaced cable segments.

15. A method of performing an earth ground test as claimed in Claim 14, wherein the length of the cable segments is one of:
about 5 meters;
about 10 meters;
slightly greater than 3/2 of the depth that the electrode is disposed in the earth; and
slightly greater than a radius of a sphere of influence for one of the electrodes.
